# EUROPEAN PATENT SPECIFICATION

(11) **EP 2 079 856 B1**
(45) Date of publication and mention of the grant of the patent: **23.02.2011**
(21) Application number: 07810814.9
(22) Date of filing: 25.07.2007
(51) Int. Cl.: H01L 21/00

(54) **METHOD AND APPARATUS FOR SINGLE-SIDED ETCHING**
VORRICHTUNG UND VERFAHREN ZUR EINSEITIGEN ÄTZUNG
APPAREIL ET PROCÉDÉ POUR GRAVER UN SEUL CÔTÉ

(30) Priority: 16.08.2006 US 505658
(43) Date of publication of application: 22.07.2009
(73) Proprietor: Sunpower Corporation, San Jose, CA 95134 (US)
(72) Inventor: PASS, Thomas P., San Jose, CA 95118 (US)
(74) Representative: Grünecker, Kinkeldey, Stockmair & Schwanhäusser Anwaltssozietät
(86) International application number: PCT/US2007/016817
(87) International publication number: WO 2008/020974

(56) References cited:
- JP-A- 11 278 626
- US-A- 4 227 983
- US-A- 5 773 088

## Description

This invention relates to a method and apparatus for single-sided etching.

Document US 5,773,088 discloses a method and a device to deposit thin films on, for example, belts. The substrate to be coated is, for example, a flexible web, which is transported by a transport mechanism comprising a supply wheel and a take-up wheel. The apparatus has a housing which is divided into two vacuum chambers, wherein in one of the vacuum chamber a treatment source assembly is provided. A gate valve is arranged between the two chambers. While the gate valve is open, the lower surface of the web may be coated. This document does not relate to an etcher to etch a single side of a wafer. This document does not show a perforated belt position against the vacuum chamber. This document also does not show that the backside of the wafer is disposed against the belt and that the vacuum chamber is configured to create a pressure differential which protects the backside of the wafer from etchant, wherein the pressure differential also secures the wafer to the belt.

Reference is also made to prior art document JP-A-11 278 626.

Etchers that simultaneously etch two sides of a wafer are currently available. One such etcher is provided by Rena Sondermaschinen GmbH of Germany. Rena provides a horizontal etching tool that processes wafers by transporting the wafers through chemical baths using horizontal shafts with rollers. The wafers are transported horizontally, sequentially, and in multiple lanes through the baths while in contact with the rollers on top and bottom sides. The wafers are exposed to chemistry from both sides, either through submersion, spray, or a combination of both.

Present etchers proclaiming to provide single-sided etching focus on etching a single side of a wafer, but do not ensure at only a single side is etched. Procedures are not implemented to ensure that only a single side of the wafer (e.g., a front side) is etched often because the wafer is not planar, the surface features of the wafer prevent such one-sided etching, and/or the designers of the etcher have not determined how to seal the wafer accurately along the edge without exposing some of the backside or covering some of the front side, or how to ensure that only one side is etched practically when the wafer shape varies. Most allegedly single side etchers rely in some form on etch rate differences between liquid versus gas phases to minimize, rather than prevent, backside etching.

For example, Rena provides a version of their etcher which attempts to etch a single side of a wafer, but does not ensure that only a single side is etched. The etcher is modified in order to locate wafers at the upper surface of the liquid. The flow of the pumps is adjusted to reduce surface turbulence. In this version, the submersion tank section of the etcher has no liquid sources other than the bath, e.g., no spray assemblies. There may be no rollers contacting the top of the wafers. With a wafer in this location, a meniscus forms aground the wafer's edge and the lower surface of the wafer contacts the liquid chemistry. Schmidt-solar of Germany also provides an etcher that attempts to etch a single side of a substrate based on surface tension, similar to that of Rena.

Other conventional etchers, rather than relying essentially on surface tension to etch a single side of a wafer, rely on spinning the wafer. These etchers use a single wafer chuck upon which a wafer is concentrically placed, held in place by vacuum or edge pins, and spun at high rotational rates while chemistries are dispensed on the exposed side. The etchers spin chemistry off the surface of the wafer to prevent contact with the side of the wafer in contact with the chuck. Some of these etchers seal the back side of the wafer with an o-ring to prevent chemical from contacting the back side of the wafer. Some of these etchers purge with inert gas the space between the back side of the wafer and the spin chuck created by the o-ring diameter. Others spray the back side of the wafer with water to prevent etching of the back side.

Another conventional etcher, rather than spinning the wafer, calls for statically positioning a wafer while exposing the wafer to a chemical vapor, e.g., a heated chemical vapor. Specifically, this etcher requires that the wafer be placed on a chimney such that the lower surface of the wafer is exposed to an enclosed chemical vapor source and the upper surface of the wafer is vented.

EnviroEtch™ of Rhode Island provides an etcher that also uses a vapor etch. The etcher from EnviroEtch™ uses a vapor etchant to etch top surfaces of flat substrates without implementing any mechanism preventing either the vapor etchant or condensation of the vapor etchant from contacting the bottom surfaces of the substrates.

Some conventional etchers etch a wafer positioned against a mechanical seal, such as an o-ring. Typically, a jig is also used. The wafer is held against the seal on the jig by a variety of clamps Including vacuum and mechanical clamps. The jig, with the wafer, is exposed to and/or processed through the chemistry.

It is the object of the present invention to provide a method and an apparatus to etch a single side of a wafer in an easy and reliable manner.

This object is met by the features of claim 1 and 16.

The present invention is illustrated by way of example and not limitation in the figures of the accompanying drawings, in which like references indicate similar elements and in which:

Figure 1 is a block diagram of an etcher in accordance with one embodiment the invention;

Figure 2A is a flow diagram of one embodiment of a method to etch a wafer using the etcher of Figure 1;

Figure 2B is a flow diagram providing exemplary details of the embodiment shown in Figure 2A;

Figure 3 is a block diagram of an alternate embodiment of an etcher;

Figure 4 is a block diagram of another alternate embodiment of an etcher; and

Figures 5A-5C are block diagrams of various embodiments of perforated belts used in the etcher of Figure 1.

A method and apparatus for single-sided etching is disclosed. The etcher includes a vacuum chamber; a perforated belt positioned against the vacuum chamber and an etch chamber positioned on an opposing side of the perforated belt relative to the vacuum chamber. The etch chamber has an opening through which an etchant is released. The vacuum chamber is configured to create a pressure differential which protects the back side of the wafer from the etchant. In use, a back side of a wafer is disposed against the perforated belt. The front side of the wafer is exposed to the released etchant. The pressure differential secures the back side of the wafer to the belt and/or extracts through a perforation of the belt etchant not deposited on the front side of the wafer. The front side of the wafer is etched, while the back side of the wafer is not.

. In the following detailed description, numerous specific details are set forth in order to provide a thorough understanding of the present invention. However, it will be apparent to one of ordinary skill in the art that these specific details need not be used to practice the present invention. In other circumstances, well-known structures, materials, or processes have not been shown or described in detail in order to avoid unnecessarily obscuring the present invention.

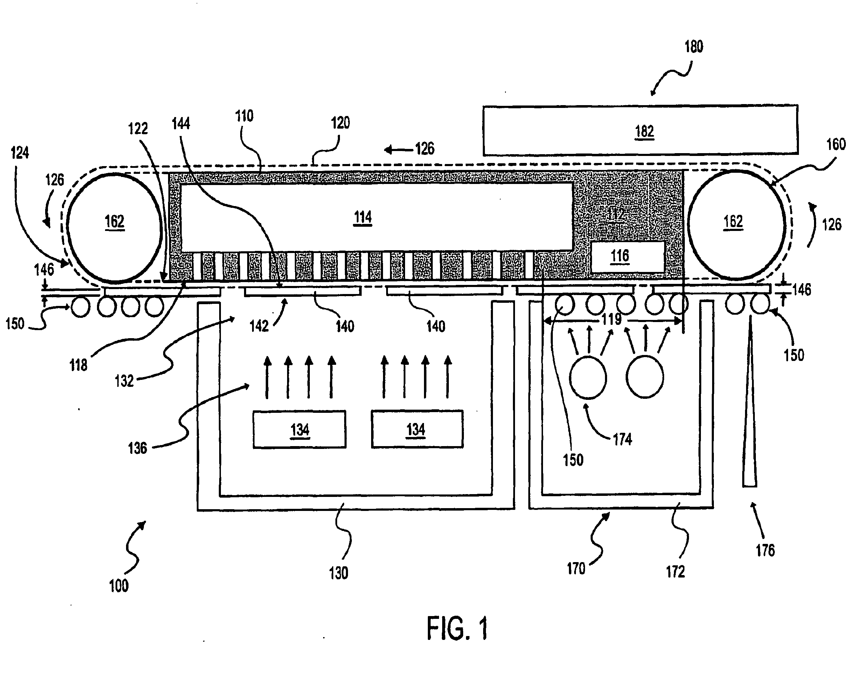

Figure 1 depicts an etcher 100 In accordance with one embodiment of the present invention. The etcher 100 includes a vacuum chamber 110, a perforated belt 120, and an etch chamber 130. The vacuum chamber 110 includes a housing 112, a vacuum plenum 114 (which may have multiple chambers), and an optional heater 116. In Figure 1, the vacuum chamber 110 also includes a porforated-surface 118.

The perforated belt 120 includes a surface 122, sometimes referred to as the belt's internal surface, and a surface 124, sometimes referred to as the belt's external surface. The surface 122 (the belt's internal surface) comes into direct contact with the vacuum chamber 110, e.g., by sliding against the perforated surface 118. The surface 124 (the belt's external surface) does not come in direct contact with the vacuum chamber 110. In use, the belt's external surface comes into direct contact with wafers.

The etch chamber 130 includes an opening 132 and one or more trays 134. The opening 132 is sized to admit release of an etchant there through. Each tray 134 is sized and configured to hold etchant. In the etcher of Figure 1, the one or more trays 134 heat chemical etchant to a vapor state, e.g., into a vapor etchant 136. Heating the etchant increases both the partial pressure (more mass) and reactivity of the vapor, thereby allowing for faster etching. Some etchant chemistries have sufficient vapor pressure at room temperature such that heating is optional for vapor etching to occur, e.g. in the case of hydrofluoric (HF) acid vapor etching. The chemical properties of the etchant depend on the wafer being etched.

In Figure 1, the etcher 100 also includes rollers 150, a belt tightening system 160, a wafer cleaning subsystem 170, and a belt cleaning subsystem 180. The belt tightening system 160 includes belt rollers 162 separated from each other by a distance sufficient to hold the belt 120 taut. In Figure 1, the belt tightening system 160 holds the belt 120 taut, but slideable against the housing 112 of the vacuum chamber 110. The belt tightening system 160 prevents the belt 120 from drooping, reducing any gaps which may otherwise exist between the belt 120 and the vacuum chamber 110.

The wafer cleaning subsystem 170 includes a rinse and drying tank 172, including dispensers 174, and an air knife 176. In use, the dispensers 174 of the rinse and drying tank 172 dispense a substance (e.g., deionized (DI) water, not shown) that cleans etchant (e.g., hydrofluoric (HF) acid, buffered oxide etchant (BOE), or potassium hydroxide (KOH)) from wafers. The air knife 176 blows air onto the rinsed wafers to assist in drying the wafers.

The belt cleaning subsystem 180 includes components to clean the belt 120 after each potential exposure to etchant. In Figure 1, the belt cleaning subsystem 180 includes a heater 182 to heat the belt 120 after etchant has been rinsed from the belt 120 via the rinse and drying tank 172.

In Figure 1, wafers 140 are also shown in order to depict how wafers are etched using the etcher 100. Each wafer 140 includes a front side 142 and a back side 144. The front side 142 is the side which is to be etched. The back side 144 is the side which is to be protected from etching.

In use, a wafer 140 is transported into the etcher 100 using rollers 150. A distance 146 between the rollers 150 and the belt 120 is sized to allow the wafer 140 to pass between the rollers 150 and the belt 120. For example, when the wafer 140 is a solar cell wafer having a thickness of 100 microns, the distance 146 is approximately the same value (i.e., approximately 100 microns) to allow the wafer 140 to pass between the rollers 150 and the belt 120. In certain configurations, the distance 146 is in the range of approximately 100-250 microns to allow for wafers 140 having a thickness of approximately 100 to approximately 250 microns to pass between the rollers 150 and the belt 120. Alternatively, other types of wafers (e.g., silicon wafers used in the semiconductor industry) and wafers having thicknesses of less than 100 microns (e.g., approximately in the range of 50 to 80 microns) to greater than 250 microns may be used. Accordingly, in other implementations, the distance 146 may be, for example, approximately in the range of 50 to 250 microns to permit the etcher to support wafers having thicknesses approximately in the range of 50 to 250 microns. The performance of the etcher will generally improve as the thickness of the wafer decreases because, as described herein, the vacuum sealing and support provided to the wafer improves with decreasing wafer thickness.

In one embodiment, the distance between the rollers and the belt is generally smaller (e.g., similar to the thickness of the wafers being etched) near the entrance of the wafer (where the wafers enter into the etcher), and larger (e.g., significantly larger than the thickness of the wafer) in a section 119. In such an embodiment, the wafers are closer to the belt at the entrance, allowing the vacuum chamber to draw the wafer towards the belt until the wafer contacts the belt directly, and the vacuum chamber is able to hold the wafer against the belt. After etching, the wafer may be supported only by the rollers in section 119, and not by the belt, as described below for one implementation. Having the distance between the belt and the rollers in section 119 be significantly larger than the thickness of the wafer provides a space between the belt and the wafer in that section. Using this space, the wafer cleaning subsystem 170 is also capable of cleaning the belt, as described in more detail herein.

The distance 146 may change to accommodate different wafers. For example, the etcher 100 may be configured so that the distance 146 is approximately 100 microns for one batch of wafers, and then reconfigured so that the distance 146 is approximately 250 microns for another batch of wafers. This change may be implemented automatically or manually.

As the wafer 140 is transported into the etcher 100 via the rollers 150, the perforated belt 120 moves in the direction of arrows 126. The belt rollers 162, which hold the belt 120 taut, in use, rotate to move the belt 120 in the direction indicated by the arrows 126. In Figure 1, as the belt rollers 162 rotate, the belt 120, which is at least partially positioned against the vacuum chamber 110, slides against the vacuum chamber 110, e.g., against the perforated surface 118. The back side of the wafer 140 comes into contact with the external surface of the belt 120, and is disposed against the belt 120.

The vacuum plenum 114 of the vacuum chamber 110 creates a negative pressure area within the vacuum chamber 110 such that a pressure differential is created between opposing sides of the belt 120, i.e., between the internal surface side of the belt and the external surface side of the belt. Accordingly, in Figure 1, creating a pressure differential includes providing a vacuum chamber 110 on a side of the belt 120 which does not come into direct contact with the wafer 140, in this case, the internal surface side. In certain configurations, this pressure differential is used to secure the wafer 140, which has its back side disposed against the belt 120, to the belt 120.

In certain configurations, the pressure differential is a primary mechanism for securing the wafer 140 to the belt 120. For example, in Figure 1, the diagram depicts the vacuum chamber 110 being above a portion of the belt 120, and the etch chamber 130 being below the portion of the belt 120. The perforated surface 118 of the vacuum chamber 110 is a perforated bottom surface. Gravity pulls the wafer 140 downward, towards the etch chamber 130. In this configuration, the pressure differential is a primary mechanism for securing the wafer 140 to the belt 120 while the wafer 140 is being exposed to the etchant. The back side of the wafer 140, disposed against the belt 120, covers at least one perforation of the belt 120. The pressure differential holds the wafer 140 up against the belt 120 via this perforation, like a suction. The force provided by the pressure differential is sufficiently large to counteract the force of gravity on the wafer 140. The pressure differential created may vary according to the wafer 140 being etched, being smaller when etching thinner (lighter) wafers, and larger when etching thicker (heavier) wafers. The wafer 140 is fully supported against the firm backing of the belt 120.

In Figure 1, as the wafer 140 is transported through the etcher 100 via the belt 120, the wafer 140 passes the opening 132 of the etch chamber 130. In Figure 1, chemical etchant is released in a vapor state e.g., as a vapor etchant 136. For example, the chemical etchant may be heated in the etch tray 134 to a vapor state and release, or the chemical etchant may have sufficient vapor pressures at the ambient temperature (e.g., the room temperature or the temperature within the etch chamber 130) such that heating is optional. The vapor etchant 136 is released from the etch chamber 130 through the opening 132. As the wafer 140 passes the opening 132, the front side 142 of the wafer 140 is exposed to the etchant. This exposure is sometimes referred to as depositing etchant on the wafer. Because, in Figure 1, the etch chamber 130 is below the wafer 140, the vapor etchant 136 naturally rises up through the opening 132, depositing on the front side 142 of the wafer 140 as the wafer 140 passes.

In Figure 1, the pressure differential created by the vacuum chamber 110 extracts the vapor etchant 136 through one or more perforations of the belt 120 not covered by a wafer 140. The extracted etchant is etchant which is not used to etch the front side of the wafer, e.g., not deposited on the front side of the wafer (sometimes referred to as extraneous etchant). By extracting the extraneous etchant using the pressure differential created by the vacuum chamber 110, the back side of the wafer 140 is not exposed to the etchant. The pressure differential draws the extraneous etchant away from the back side 144 of the wafer 140, and into the vacuum chamber 110, eliminating the ability of the vapor etchant to etch the back side 144 of the wafer 140. The vacuum chamber 110 properly exhausts the etchant through an exhaust (not shown) coupled to the vacuum plenum 114.

In Figure 1, to prevent vapor etchant condensation from potentially contacting the back side 144 of a wafer 140, the vacuum chamber 110 is heated. Heating the vacuum chamber 110 prevents the vapor etchant 136 from condensing on the vacuum chamber 110 (e.g., condensing inside the housing 112) and falling down and back through a perforation, thereby preventing the vapor etchant 136 from potentially contacting the back side 144 of a wafer 140. In Figure 1, the vacuum chamber 110 includes a heater 116 to heat a surface of the vacuum chamber 100 to a temperature which reduces condensation of the vapor etchant 136 on the vacuum chamber 110. The temperature is dependent on several factors, including the etchant used (type and concentration), vacuum pressure, evacuated gas flow rate, and how fast the etchant enters the chamber (which can depend on, for example, the size of the perforations of the vacuum chamber). In one embodiment, a gas stream (e.g., of air or nitrogen) is injected into the vacuum chamber to reduce the etchant partial pressure and to achieve a desired combination of vacuum pressure and gas flow rate. Accordingly, the 'vacuum' in the vacuum chamber may not be a static vacuum. The pressure in the vacuum chamber may be controlled, e.g., by controlling the exhaust flow, using multiple chambers, injecting gas into the vacuum chamber, controlling the partial pressure of the etchant, and heating the vacuum chamber.

In an exemplary embodiment, any surface of the vacuum chamber 110 exposed to the vapor etchant is at a temperature that is sufficiently high to ensure that etchant near and contacting that surface exists in a gas/vapor state. This temperature sufficiently reduces or effectively eliminates condensation of the vapor etchant 136 on the vacuum chamber 110. Achieving this temperature uniformly throughout the vacuum chamber 110 is design dependent as heat loss occurs by thermal transfer to the belt, wafers, and/or etch chamber. Achieving this temperature (that ensures that any surface of the vacuum chamber exposed to the etchant is exposed only to gaseous/vapor etchant) also depends on the material and thickness of perforated surface(s) of the vacuum chamber and physical constraints involved in installing heaters in the vacuum chamber. Because the perforated surface(s) will have generally the most exposure to the etchant, achieving this temperature at the perforated surface(s) (e.g., having the perforated surface 118 of the vacuum chamber 110 reach this target temperature) is generally more significant. Additionally, this target temperature may not be a single absolute temperature, but instead may differ depending on the surface under consideration, and may also be a target range of temperatures.

Heating the vacuum chamber 110, and in particularly, the surface (e.g., the bottom surface 118) that contacts the belt may also lead to heating of the belt. When the wafer comes into contact with the belt, the temperature of the wafer may increase, which will generally increase the reactivity of the etchant on the wafer surface. Therefore, heating the wafer, directly or indirectly, by heating the belt directly or by heating the vacuum chamber directly, also allows for faster etching. Accordingly, the rate of the etching may be controlled (controlling reactivity), e.g., by controlling the temperature of the vacuum chamber, the temperature of the belt, the temperature of the wafer, and/or the temperature of the etchant.

In certain configurations, to prevent condensation from potentially contacting the back side 144 of a wafer 140, the vacuum chamber 110 creates a sufficiently large pressure differential such that condensation is prevented from dripping down through one or more of the perforations of the belt 120 and contacting the back side 144 of a wafer 140. In such configurations, an upward force exerted on the condensation droplets by the pressure differential (and any other relevant forces, e.g., friction) exceeds the downward force exerted by gravity on the droplets. Accordingly, the condensation is prevented from dripping down and potentially contacting the back side 144 of a wafer 140.

Accordingly, the etcher 100, in use, exposes the front side 142 of a wafer 140 to etchant, while protecting the back side 144 of the wafer 140 from the etchant. The front side 142 of the wafer 140 is not dragged against or across any abrading surfaces while being etched. The back side 144 of the wafer 140, disposed against the perforated belt 120, is not dragged against or across any abrading surfaces while the wafer 140 passes through the etcher 100.

In Figure 1, as the wafer 140 continues through the etcher 100, the wafer 140 passes into a section 119 where the perforations of the bottom surface 118 of the vacuum chamber 110 cease. In Figure 1, in the section 119, the wafer 140 is no longer held up against the belt 120 by the pressure differential created by the vacuum chamber 110. As shown in Figure 1, at that point, the front side 142 of the wafer 140 contacts the rollers 150. The rollers 150 support the wafer 140 and transport the wafer 140 pass the wafer cleaning subsystem 170, including through the rinse and drying tank 172, where the wafer 140 is cleaned. The dispensers 174 dispense a cleaning solution, e.g., deionized (DI) water, to clean the etchant (and any undesired material resulting from the etching) from the wafer 140. The air knife 176 blows air onto the rinsed wafer 140, helping to dry the wafer 140. The rollers 150 pass the wafer 140 through the end of the etcher 100, where the wafer 140 may be processed further.

In the embodiment shown, the belt extends over and moves through the wafer cleaning subsystem, allowing the wafer cleaning system to clean the wafer and the belt simultaneously. In one embodiment, the belt does not extend over or continue to move through the wafer cleaning subsystem 170. For example, the vacuum chamber housing 112 and the belt rollers 162 may have dimensions and an arrangement such that neither extends over the wafer cleaning subsystem 170. In such an arrangement, the belt 120 will not extend over or move through the wafer cleaning subsystem.

In one embodiment, to pass the wafer 140 through the wafer cleaning subsystem, the wafer cleaning subsystem 170 includes a roller assembly having top and bottom rollers. The wafer cleaning subsystem 170 may also include a horizontal cleaner.

When the wafer 140 passes through the wafer cleaning subsystem 170, portions of the external side 124 of the belt 120 between wafers 140 may be exposed to the cleaning solution. Accordingly, a portion of the belt 120 may also be cleaned by the wafer cleaning subsystem 170. If the etcher is configured such that a space is between the wafer and the belt when the wafer is passing through the wafer cleaning subsystem 170, the belt may also be cleaned by the cleaning solution via this space. Therefore, in one embodiment, the wafer cleaning subsystem 170 may be considered to be a part of the belt cleaning subsystem 180.

The belt cleaning subsystem 180 includes components to clean the belt 120 after each potential exposure to etchant. In Figure 1, the belt cleaning subsystem 180 includes a heater 182 to heat the belt 120 after etchant has been rinsed from the belt 120 by the rinse and drying tank 172.

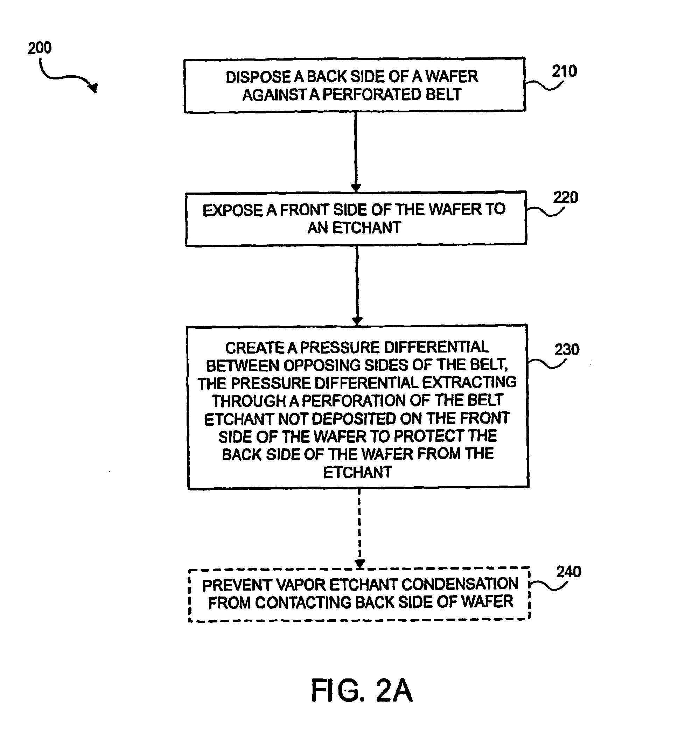

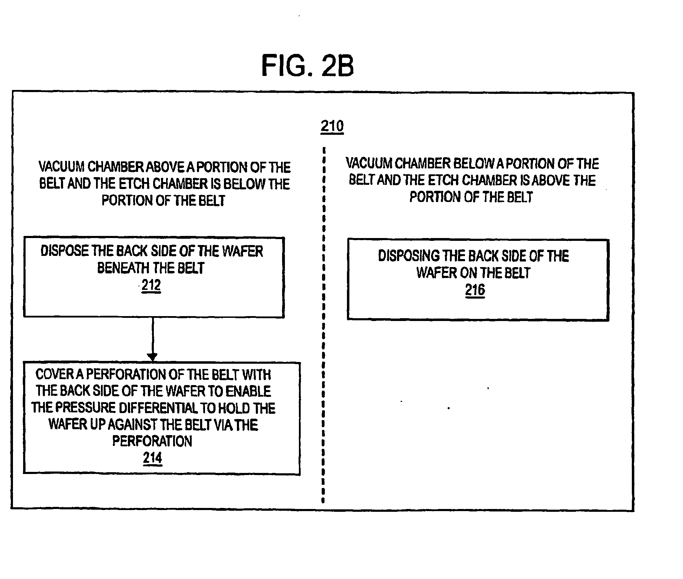

The usage of the etcher 100 discussed above corresponds with the operations shown in Figure 2A. Figure 2A shows a method 200 to etch a single side of a wafer 140 in accordance with one embodiment of the present invention. At operation 210, a back side (e.g., 144) of a wafer (e.g., 140) is disposed against a perforated belt 120. Operation 210 is discussed in more detail below with regard to Figure 2B.

At operation 220, the front side (e.g., 142) of the wafer (e.g., 140) is exposed to an etchant (e.g., 136). As discussed above, the etchant may include a vapor etchant 136, formed by heating a chemical etchant into a vapor state using a heated etch tray (e.g., 134). The etchant may also be a liquid etchant that is dispensed onto the wafer 140, e.g., by spraying (for example, a mist or aerosol), as described in more detail below. When the etch chamber 130 is below the belt, e.g., in Figure 1, a vapor etchant 136 is advantageous because the vapors naturally flow up through the opening 132 of the etch chamber 130. The flow of the vapors is readily manipulated (e.g., by the pressure differential created by the vacuum chamber 110 through perforations of the belt 120 not covered by wafers 140).

At operation 230, the pressure differential is created between opposing sides of the belt (e.g., between the internal surface side 122 and the external surface side 124). The pressure differential extracts etchant not deposited on the front side 142 of the wafer 140 to protect the back side 144 of the wafer 140 (disposed against the perforated belt 120) from the etchant. Therefore, the front side 142 of the wafer 140 is etched, while the back side 144 of the wafer 140 is not.

At optional operation 240, vapor etchant condensation is prevented from contacting the back side 144 of the wafer 140. In certain configurations, this operation includes, heating the vacuum chamber 110 to a temperature which prevents vapor etchant 136 from condensing on a surface of the vacuum chamber 110. In certain configurations, the operation 240 includes creating a negative pressure in the vacuum plenum 114 sufficiently large to prevent condensation that may form from falling back through a perforation of the belt 120 and contacting the back side 144 of the wafer 140.

Figure 2B shows exemplary details of operation 210 in accordance with embodiments of the present invention. The left side of Figure 2B is relevant to implementations similar to Figure 1, in which the vacuum chamber 110 is above a portion of the belt 120 and the etch chamber 130 is below the portion of the belt 120. The right side of Figure 2B is relevant to implementations similar to Figure 1, but in which the vacuum chamber 110 is below a portion of the belt 120, and the etch chamber 130 is above that portion of the belt 120 (e.g., by viewing Figure 1 upside down).

As shown on the left side of Figure 2B, operation 210 (disposing the back side 144 of the wafer 140 against the belt 120) includes, at operation 212, disposing the back side 144 of a wafer 140 beneath the belt 120, and, at operation 214, covering at least one perforation of the belt 120 with the back side 144 to enable the pressure differential (e.g., created at operation 230) to hold the wafer 140 up against the belt 120 via the perforation. As discussed above, in this implementation, the pressure differential is a primary mechanism for securing the wafer 140 to the belt 120 while the wafer 140 is being exposed to the etchant.

The etcher 100 of Figure 1 also functions when the vacuum chamber 110 is below a portion of the belt 120, and the etch chamber 130 is above that portion of the belt 120 (e.g., by viewing the diagram upside down). In such an implementation, as indicated on the right side of Figure 2B, operation 210 (disposing the back side 144 of the wafer 140 against the belt 120) includes, at operation 216, disposing the back side 144 of a wafer 140 on the belt 120. Gravity pulls the wafer 140 downward, in this case, towards the belt 120. In this configuration, the pressure differential created at operation 230 may still be part of the mechanism for securing the wafer 140 to the belt 120, but the force provided by the pressure differential can be less than in other implementations because the pressure differential is not attempting to counteract the force of gravity.

When the etch chamber 130 is above the wafer 140, vapor etchant 136 will not naturally flow up and out through the opening 132 because the opening 132 is below the etch tray 134, not above the etch tray 134. Accordingly, in this implementation, the etch chamber 130 may include an additional mechanism (e.g., a pressure nozzle) to force the vapor etchant 136 down towards the opening 132 and the wafer 140. Alternatively or additionally, the vapor etchant may be forced down towards the wafers using other techniques. For example, the gas pressure may be increased by increasing the temperature of the etch chamber, or the negative pressure of the vacuum chamber may be increased to increase the force drawing the vapor etchant into the vacuum chamber. When the etchant deposited on the wafer 140 is a liquid etchant rather than a vapor etchant, the liquid etchant will naturally fall down towards the wafer 140. Accordingly, liquid etchants may be particularly suited for the implementation indicated by the right side of Figure 2B. A mechanism (e.g., a pressure nozzle) to force etchant down and out the opening 132 may still be beneficial, e.g., to control the quantity, pressure, and direction the liquid etchant is released through the opening 132. The pressure differential created through perforations of the belt 120 (which is below the wafer 140 in this implementation) draws any extraneous liquid etchant away from the back side 144 of the wafer 140 and into the vacuum chamber 110. The vacuum chamber 110 again properly disposes of the extraneous etchant.

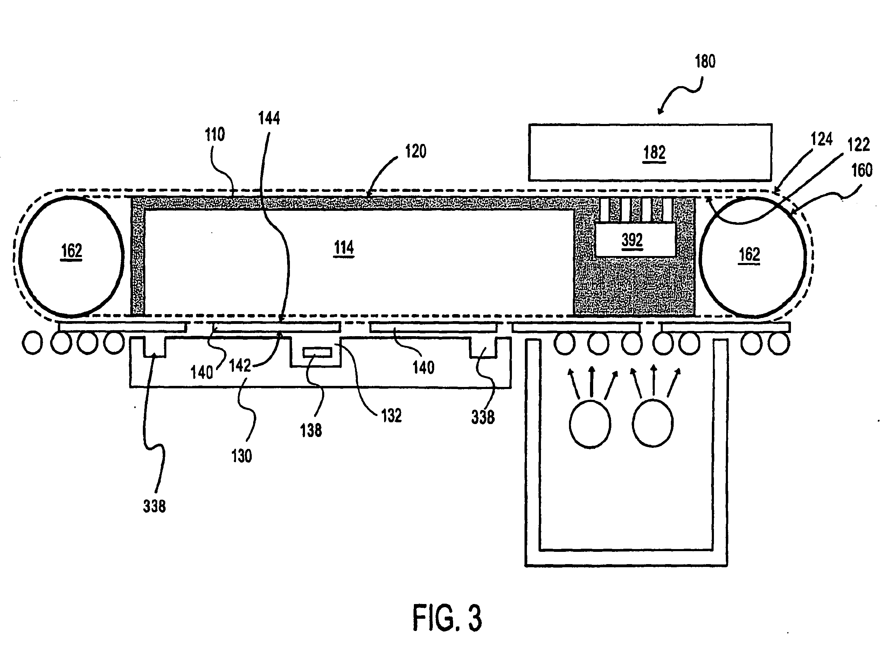

Figure 3 is a block diagram of an alternate embodiment of an etcher. Figure 3 shows modifications to the etcher of Figure 1 which may be incorporated when the etcher is used in particular situations. For example, in Figure 3, the vacuum chamber 110 does not have a perforated bottom surface. Rather, the belt tightening system 160, including the belt rollers 162, hold the belt sufficiently taut such that the pressure differential created by the vacuum plenum 114 will not significantly bend the belt 120 into the vacuum chamber 110. Wafers 140 are still held secure against the belt 120, which slides against a surface of the vacuum chamber 110.

This configuration may be particularly suited for implementations that use a perforated belt 120 made of a material that is sufficiently thick such that the pressure used to hold the wafer 140 secure against the belt 120 is less than the pressure that would cause the belt 120 to bend into the vacuum chamber 110. This configuration may also be particularly suited for implementations In which the vacuum chamber 110 provides sufficient surface area for the belt 120 to slide against (e.g., by having thick housing walls) such that the belt 120 is not readily susceptible to bending into the vacuum chamber 110. This configuration may also be particularly suited for implementations that do not use the pressure differential created by the vacuum chamber 110 as the primary mechanism to hold the wafer 140 secure against the belt 120, e.g., when the wafer 140 is disposed on the belt 120 and gravity assists in holding the wafer against the belt 120.

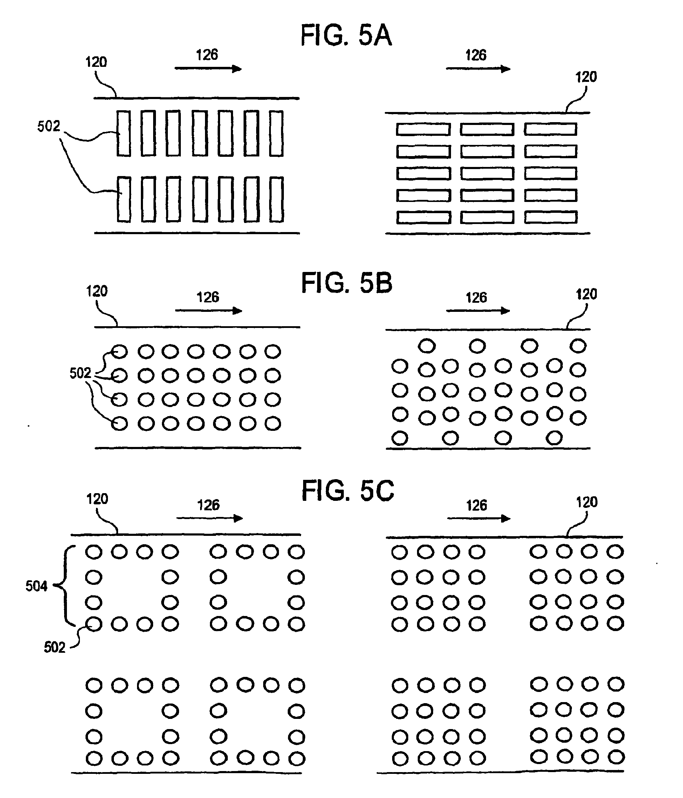

In Figure 3, the etch chamber 130 also includes exhausts 338 configured to extract etchant not deposited on the wafer 140. In use, etchant (e.g., a vapor etchant and/or a liquid etchant) from an etchant source 138 is released from the opening 132. The flow of the etchant is influenced by the exhaust 338, which draws some, or all, of the extraneous etchant through the exhaust 338. The pressure differential protects the back side 144 of the wafer 140 from etchant by holding the wafer 140 secure against the belt 120 (without batching, edge gasketing, or other mechanical sealing mechanisms, e.g., o-rings). The front side 142 of the wafer 140 is exposed to the etchant, and undeposited etchant is removed via one or more of the exhausts 338. In such a configuration, a belt 120 such as described in Figures 5C below, is suitable because extraneous etchant may be entirely removed via the exhaust 338 rather than via perforations in the belt 120.

In Figure 3, the etch chamber 130 also includes a pressurized chamber 392. The pressurized chamber is located in or adjacent to the vacuum chamber housing, on the internal surface 122 side of the belt 140. The pressurized chamber 392 is part of the belt cleaning subsystem 180. In use, as part of a process for cleaning the belt 120, the pressurized chamber 392 forces air through perforations of the belt 120, expelling any residual etchant or cleaning solution remaining on the belt 120 before the belt 120 comes into contact with more wafers 140.

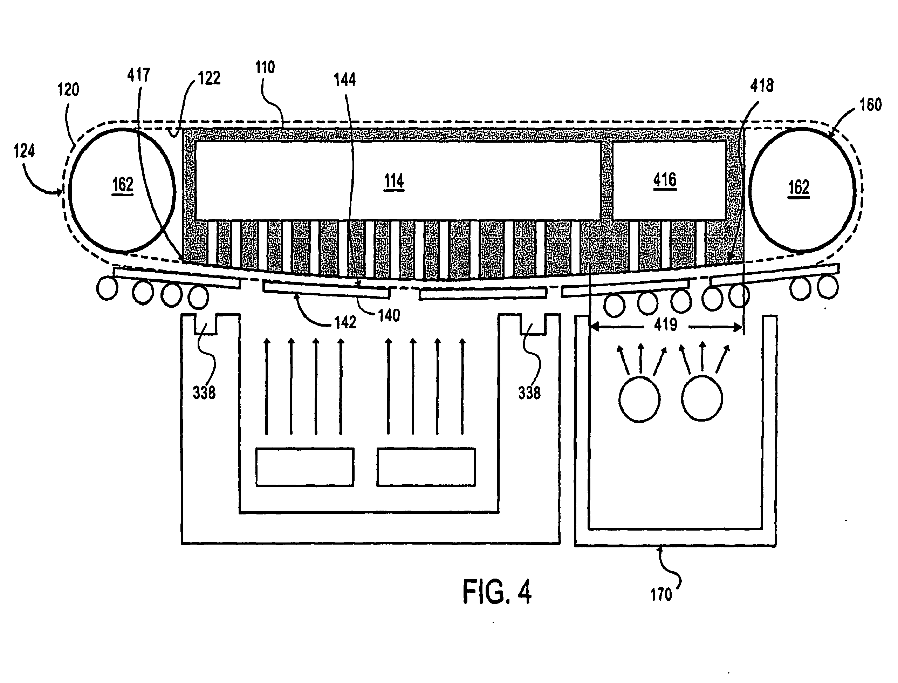

Figure 4 is a block diagram of another alternate embodiment of an etcher. Figure 4 shows additional modifications to the etcher of Figure 1 which may be incorporated when the etcher is used in particular situations. Figure 4 depicts the belt 120 slightly drooping. This may occur when, in practice, the belt tightening system 160 does not hold the belt 120 sufficiently taut to prevent such drooping. In some instances, belt drooping may occur over time due to wear and tear. To prevent such drooping from potentially affecting the performance of the etcher, in Figure 4, the vacuum chamber 110 includes a curved bottom surface 418. The curved bottom surface 418 has a curvature corresponding to the curvature of the belt 120 after positioned in place in the etcher. The curved bottom surface 418 of the vacuum chamber 110 reduces a gap 417 which may otherwise occur between the belt 120 and the bottom surface of the vacuum chamber 110. This curvature provides additional support to a drooping belt, allowing the belt 120 to slide against a surface of the vacuum chamber 110 even when the belt 120 is drooping.

This configuration is particularly suited for etching relatively thinner wafers (approximately in the range of 50 to 250 microns thick) such as those used in the solar power industry. Thinner wafers are more flexible, and therefore are more amiable to bending when disposed against a belt sliding along a curved surface, than thicker wafers (e.g., those used in the semiconductor industry).

Figure 4 also shows perforations of the bottom surface 418 of the vacuum chamber 110 extending pass the section where the front side 142 of a wafer 140 is exposed to etchant, and into a section 419. By extending the perforations into the section 419, a pressure differential between opposing sides of the belt 120 can continue to hold the wafer 140 up against the belt 120 while the wafer 140 passes through the wafer cleaning subsystem 170. In Figure 4, the pressure differential for this section is created by a separate vacuum plenum 416. Using a separate vacuum plenum 416 is particularly advantageous when the pressure differential is used not only to secure the wafer 140 to the belt 120, but also to draw cleaning solution away from the back side 144 of the wafer 140. The solution drawn into the separate vacuum plenum 416 may include a mixture of cleaning solution chemicals and etchant chemical. Using a separate vacuum plenum 416 allows the etcher to dispose of this mixture through a separate disposal system, e.g., a separate exhaust. Additionally, the pressure created by the separate vacuum plenum 416 may be less than the pressure created by the vacuum chamber 114. In some implementations, this lower pressure allows the wafer to lower down onto the rollers, providing the space between the wafer and the belt used for cleaning the belt as described herein, while still drawing vapors into the separate vacuum plenum.

Figures 5A-5C depict top views of various embodiments of the perforated belt 120. In Figure 5A, perforations 502 of the belt are shaped as slits. On the left side of Figure 5A, the slits run in a direction perpendicular to the direction of arrow 126, which is the direction the belt 120 moves through the etcher. On the right side of Figure 5A, the slits run in a direction parallel to the direction of arrow 126. In other implementations, the slits are angled relative to the direction of arrow 126, e.g., at a forty-five degree angle.

In Figure 5B, perforations 502 of belt 120 are shaped as holes. On the left side of Figure 5B, the holes are evenly spaced. On the right side of Figure 5B, the holes of each row are slightly offset from the holes of adjacent rows

In Figure 5C, perforations 502 of the belt 120 occur in a pattern matching wafer positions. On the left side of Figure 5C, the pattern 504 outlines the outer edge of wafers, in this case, relatively square wafers, e.g., those used in solar power applications. On the right side of Figure 5C, the pattern is similar to that of the left side of Figure 5C, with the addition of perforations centered within the outer edge of where the wafers would be disposed to enable the pressure differential to hold a wafer 140 more securely against the belt 120.

Using a belt 120 having perforations such as those shown in Figures 5A-5C can be advantageous particularly when a large number of wafers are to be etched. Single sided etching is accomplished without pre-etching operations to seal the back side of the wafer prior to passing the wafer into the etcher. For example, in Figures 5A-5B, the wafers are etched without taking the time to place each wafer 140 in a particular position prior to transporting the wafer 140 through the etcher. In Figures 5A-5C, the wafers are etched without taking the time to place each wafer 140 in, for example, a single-wafer chuck or jig prior to transporting the wafer through the etcher. The wafers in one batch may vary in shape and size with little or no detriment to the performance of the system.

Additionally, multiple wafers can be etched simultaneously. Each belt 120 shown in Figures 5A-5C has dimensions sufficient to transport parallel rows of wafers simultaneously. For example, in Figure 5C, both the belt 120 on the left of Figure 5C and the belt on the right of Figure 5C are dimensioned to carry parallel rows of wafers in a manner similar to a double file line. The belt 120 may be dimensioned to transport parallel rows of wafers in a manner similar to a triple file line, or more, as well. In some implementations, a belt 120 is dimensioned to carry wafers in a single line.

Although shown as perforations for the belt, the shapes of the perforations shown In Figure 5A-5C may also be those of the vacuum chamber. The shape of the perforations of the belt and the shape of the perforations of the vacuum chamber may be the same or may differ. For example, in one implementation, the perforations of the belt are generally circular in shape (e.g., those of Figures 5B and 5C), while the perforations of the vacuum chamber are generally slot-like in shape (e.g., that of Figure 5A). The slots may be angled as described above. This configuration effectively allows the belt holes to sweep over the slots of the vacuum chamber at a frequency that prevents accumulation of condensed etchant. In other embodiments, other combinations of shapes of belt perforation and shapes of vacuum chamber perforations are used.

In one embodiment, the etcher is formed generally of plastics (e.g., Teflon based materials) or coated metal. The material forming the etcher (or certain subsystems of the etcher) may depend on the particular use. For example, for etchers intended for etching oxides (or that will otherwise use etchants such as HF or BOE), the etcher may be generally formed from Teflon based materials like PolyVinylidine DiFluoride (PVDF). For etchers intended for etching semiconductor materials, like silicon (or that will otherwise use etchants such as KOH), the etcher may be generally formed from Polypropylene (PP), or a similar material.

In certain implementations, the material used to form the vacuum chamber (including the housing and the perforated surface) is selected based upon the expected temperature of the vacuum chamber during use and/or the structural elements that will be incorporated into the vacuum chamber. In one embodiment, the vacuum chamber is formed from Teflon coated steel, Teflon coated aluminum, or block plastics. In one embodiment, the etch chamber is formed from PVDF, natural PP, or similar material. In one embodiment, the belt is formed from a material that does not significantly stretch, e.g., a metal web with a plastic coating (e.g., a Teflon coating). The belt may also be formed of woven Teflon. In embodiments in which the belt spans vacuum chamber perforations that are significantly large relative to the belt (or embodiments such as that of Figure 3), the belt is formed from generally stiff material, including metal.

## Claims

1. A method to etch a single side of a wafer (140) comprising:
disposing a back side of a wafer against a perforated belt (122,120);
exposing a front side of the wafer to an etchant; and
creating a pressure differential between opposing sides of the belt (122, 120), the pressure differential extracting through a perforation of the belt etchant not deposited on the front side of the wafer (140) to protect the back side of the wafer from the etchant.

2. The method of claim 1, wherein the etchant comprises a vapor etchant.

3. The method of claim 1, wherein the etchant comprises a liquid etchant.

4. The method of claim 1, wherein creating the pressure differential comprises providing a vacuum chamber on a side of the belt which does not come in direct contact with the wafer.

5. The method of claim 4, wherein the etchant comprises a vapor etchant and the method further comprises preventing vapor etchant condensation from contacting the back side of the wafer.

6. The method of claim 5, wherein preventing vapor etchant condensation from contacting the back side of the wafer comprises preventing the vapor etchant from condensing on the vacuum chamber.

7. The method of claim 5, wherein preventing the vapor etchant from condensing on the vacuum chamber comprises heating the vacuum chamber.

8. The method of claim 4, further comprising controlling a pressure in the vacuum chamber.

9. The method of claim 8, wherein controlling the pressure in the vacuum chamber comprises at least one selected from the group consisting of: controlling an exhaust flow, using a vacuum plenum having multiple chambers, injecting gas into the vacuum plenum, controlling a partial pressure of the etchant, and heating the vacuum chamber.

10. The method of claim 1, wherein disposing the back side of a wafer against the perforated belt comprises disposing the back side of the wafer beneath the belt.

11. The method of claim 10, wherein disposing the back side of a wafer against the perforated belt further comprises covering a second perforation of the belt with the back side of the wafer to enable the pressure differential to hold the wafer up against the belt via the second perforation.

12. The method of claim 1, wherein disposing the back side of a wafer against the perforated belt comprises disposing the back side of the wafer on the belt.

13. The method of claim 1, wherein the wafer has a thickness approximately in a range of 50 to 250 microns.

14. The method of claim 1, further comprising: bringing the front side of the wafer into contact with a roller transporting the wafer.

15. The method of claim 14, further comprising: changing a distance between the belt and the roller.

16. An etcher comprising:
a vacuum chamber (114);
a perforated belt (120) positioned against the vacuum chamber; and
an etch chamber (130) positioned on an opposing side of the perforated belt (120) relative to the vacuum chamber,
the etch chamber (130) having an opening (132) sized to admit release of an etchant there through to etch a front side of a wafer (140) having a back side disposed against the belt (120), the vacuum chamber (114) configured to create a pressure differential which protects the back side of the wafer from the etchant, wherein the pressure differential secures the wafer to the belt and the front side (142) of the wafer is exposed to the etchant.

17. The etcher of claim 16, wherein the etchant is a vapor etchant.

18. The etcher of claim 17, wherein the vacuum chamber includes a heater (116) to heat a surface of the vacuum chamber to a temperature which reduces condensation of the vapor etchant on the vacuum chamber.

19. The etcher of claim 16, wherein the pressure differential provides a force sufficient to prevent condensation from dripping through one or more perforations of the belt and contacting the back side of the wafer.

20. The etcher of claim 16, wherein the vacuum chamber(114) is above a portion of the belt and the etch chamber (130) is below the portion of the belt.

21. The etcher of claim 18, wherein the vacuum chamber is below a portion of the belt and the etch chamber is above the portion of the belt.

22. The etcher of claim 16, wherein the pressure differential extracts through a perforation of the belt (120) etchant not deposited on the front side of the wafer.

23. The etcher of claim 16, wherein the etch chamber further comprises an exhaust configured to extract etchant not deposited on the wafer.

24. The etcher of claim 18, wherein a perforation of the belt is shaped as a slit or a hole.

25. The etcher of claim 16, wherein perforations of the belt occur in a pattern matching wafer positions.

26. The etcher of claim 16, wherein the vacuum chamber has a perforated bottom surface (118).

27. The etcher of claim 26, wherein the perforated bottom surface of the vacuum chamber is curved.

28. The etcher of claim 26, further comprising:
a belt roller (162) coupled to the belt to slide the belt across the perforated bottom surface of the vacuum chamber.

29. The etcher of claim 16, wherein dimensions of the belt are sufficient to transport parallel rows of wafers simultaneously.

30. The etcher of claim 16, further comprising:
rollers adjacent to the etch chamber, a distance between the rollers and the perforated belt being in the range of approximately 50 to 250 microns.

## Patentansprüche

1. Verfahren zum Ätzen einer einzelnen Seite eines Wafers (140), das umfasst:
Anordnen einer Rückseite eines Wafers zu einem perforierten Band (122, 120);
Behandeln einer Vorderseite des Wafers mit einem Ätzmittel; und
Erzeugen eines Druckunterschiedes zwischen einander gegenüberliegenden Seiten des Bandes (122, 120), wobei durch den Druckunterschied über eine Perforation des Bandes nicht auf die Vorderseite des Wafers (140) aufgebrachtes Ätzmittel abgesaugt wird, um die Rückseite des Wafers vor dem Ätzmittel zu schützen.

2. Verfahren nach Anspruch 1, wobei das Ätzmittel ein dampfförmiges Ätzmittel umfasst.

3. Verfahren nach Anspruch 1, wobei das Ätzmittel ein flüssiges Ätzmittel umfasst.

4. Verfahren nach Anspruch 1, wobei Erzeugen des Druckunterschiedes Bereitstellen einer Vakuumkammer an einer Seite des Bandes umfasst, die nicht in direkten Kontakt mit dem Wafer kommt.

5. Verfahren nach Anspruch 4, wobei das Ätzmittel ein dampfförmiges Ätzmittel umfasst und das Verfahren des Weiteren umfasst, dass verhindert wird, dass Kondensat des dampfförmigen Ätzmittels mit der Rückseite des Wafers in Kontakt kommt.

6. Verfahren nach Anspruch 5, wobei Verhindern, dass Kondensat des dampfförmigen Ätzmittels mit der Rückseite des Wafers in Kontakt kommt, umfasst, dass verhindert wird, dass dampfförmiges Ätzmittel an der Vakuumkammer kondensiert.

7. Verfahren nach Anspruch 5, wobei Verhindern, dass das dampfförmige Ätzmittel an der Vakuumkammer kondensiert, Erhitzen der Vakuumkammer umfasst.

8. Verfahren nach Anspruch 4, das des Weiteren Steuern eines Drucks in der Vakuumkammer umfasst.

9. Verfahren nach Anspruch 8, wobei Steuern des Drucks in der Vakuumkammer wenigstens einen Vorgang umfasst, der aus der Gruppe ausgewählt wird, die besteht aus:
Steuern eines Abgasstroms, Einsetzen eines Vakuumraums mit mehreren Kammern, Einleiten von Gas in den Vakuumraum, Steuern eines Teildrucks des Ätzmittels und Erhitzen der Vakuumkammer.

10. Verfahren nach Anspruch 1, wobei Anordnen der Rückseite eines Wafers zu dem perforierten Band Anordnen der Rückseite unterhalb des Bandes umfasst.

11. Verfahren nach Anspruch 10, wobei Anordnen der Rückseite eines Wafers an dem perforierten Band des Weiteren umfasst, dass eine zweite Perforation des Bandes mit der Rückseite des Wafers abgedeckt wird, um zu ermöglichen, dass der Druckunterschied den Wafer über die zweite Perforation an dem Band hoch hält.

12. Verfahren nach Anspruch 1, wobei Anordnen der Rückseite eines Wafers zu dem perforierten Band Anordnen der Rückseite des Wafers an dem Band umfasst.

13. Verfahren nach Anspruch 1, wobei der Wafer eine ungefähre Dicke in einem Bereich von 50 bis 250 µm hat.

14. Verfahren nach Anspruch 1, das des Weiteren umfasst:
Herstellen von Kontakt der Vorderseite des Wafers mit einer Walze, die den Wafer transportiert.

15. Verfahren nach Anspruch 14, das des Weiteren umfasst:
Ändern eines Abstandes zwischen dem Wafer und der Walze.

16. Ätzvorrichtung, die umfasst:
eine Vakuumkammer (114);
ein perforiertes Band (120), das zu der Vakuumkammer positioniert ist; und
eine Ätzkammer (130), die an einer in Bezug auf die Vakuumkammer gegenüberliegenden Seite des perforierten Bandes (120) positioniert ist,
wobei die Ätzkammer (130) eine Öffnung (132) aufweist, die so bemessen ist, dass sie Freisetzen eines Ätzmittels durch sie hindurch zum Ätzen einer Vorderseite eines Wafers (140) zulässt, der eine Rückseite hat, die an dem Band (120) angeordnet ist, wobei die Vakuumkammer (114) so konfiguriert ist, dass sie einen Druckunterschied erzeugt, der die Rückseite des Wafers vor dem Ätzmittel schützt, und der Druckunterschied den Wafer an dem Band hält und die Vorderseite (142) des Wafers dem Ätzmittel ausgesetzt ist.

17. Ätzvorrichtung nach Anspruch 16, wobei das Ätzmittel ein dampfförmiges Ätzmittel ist.

18. Ätzvorrichtung nach Anspruch 17, wobei die Vakuumkammer eine Heizeinrichtung (116) enthält, mit der eine Oberfläche der Vakuumkammer auf eine Temperatur erhitzt wird, durch die Kondensation des dampfförmigen Ätzmittels an der Vakuumkammer reduziert wird.

19. Ätzvorrichtung nach Anspruch 16, wobei der Druckunterschied eine Kraft erzeugt, die ausreicht, um zu verhindern, dass Kondensat durch eine oder mehrere Perforationen des Bandes tropft und mit der Rückseite des Wafers in Kontakt kommt.

20. Ätzvorrichtung nach Anspruch 16, wobei sich die Vakuumkammer (114) oberhalb eines Abschnitts des Bandes befindet und sich die Ätzkammer (130) unterhalb des Abschnitts des Bandes befindet.

21. Ätzvorrichtung nach Anspruch 16, wobei sich die Vakuumkammer unterhalb eines Abschnitts des Bandes befindet und sich die Ätzkammer oberhalb des Abschnitts des Bandes befindet.

22. Ätzvorrichtung nach Anspruch 16, wobei durch den Druckunterschied über eine Perforation des Bandes (120) nicht auf die Vorderseite des Wafers aufgebrachtes Ätzmittel abgesaugt wird.

23. Ätzvorrichtung nach Anspruch 16, wobei die Ätzkammer des Weiteren einen Austritt umfasst, der zum Absaugen von nicht auf den Wafer aufgebrachtem Ätzmittel eingerichtet ist.

24. Ätzvorrichtung nach Anspruch 16, wobei eine Perforation des Bandes als ein Schlitz oder ein Loch geformt ist.

25. Ätzvorrichtung nach Anspruch 16, wobei Perforationen des Bandes in einem Muster auftreten, das mit Wafer-Positionen übereinstimmt.

26. Ätzvorrichtung nach Anspruch 16, wobei die Vakuumkammer eine perforierte Bodenfläche (118) hat.

27. Ätzvorrichtung nach Anspruch 26, wobei die perforierte Bodenfläche der Vakuumkammer gekrümmt ist.

28. Ätzvorrichtung nach Anspruch 26, die des Weiteren umfasst:
eine Bandwalze (162), die mit dem Band gekoppelt ist, um das Band über die perforierte Bodenfläche der Vakuumkammer gleiten zu lassen.

29. Ätzvorrichtung nach Anspruch 16, wobei Abmessungen des Bandes ausreichen, um gleichzeitig parallele Reihen von Wafern zu transportieren.

30. Ätzvorrichtung nach Anspruch 16, die des Weiteren umfasst:
Walzen, die an die Ätzkammer angrenzen, wobei ein Abstand zwischen den Walzen und dem perforierten Band ungefähr im Bereich von 50 bis 250 µm liegt.

## Revendications

1. Procédé pour graver un seul côté d'une tranche (140) comprenant :
la disposition d'une face arrière d'une tranche contre une courroie perforée (122, 120) ;
l'exposition d'une face avant de la tranche à un agent de gravure ; et
la création d'un différentiel de pression entre des côtés opposés de la courroie (122, 120), le différentiel de pression extrayant de l'agent de gravure non déposé sur la face avant de la tranche (140) à travers une perforation de la courroie pour protéger la face arrière de la tranche de l'agent de gravure.

2. Procédé selon la revendication 1, dans lequel l'agent de gravure comprend une vapeur de gravure.

3. Procédé selon la revendication 1, dans lequel l'agent de gravure comprend un liquide de gravure.

4. Procédé selon la revendication 1, dans lequel la création du différentiel de pression comprend la fourniture d'une chambre sous vide sur un côté de la courroie qui n'entre pas en contact direct avec la tranche.

5. Procédé selon la revendication 4, dans lequel l'agent de gravure comprend une vapeur de gravure et le procédé comprend en outre la prévention d'un contact entre une condensation de la vapeur de gravure et la face arrière de la tranche.

6. Procédé selon la revendication 5, dans lequel la prévention d'un contact entre une condensation de la vapeur de gravure et la face arrière de la tranche comprend la prévention de la condensation de vapeur de gravure sur la chambre sous vide.

7. Procédé selon la revendication 5, dans lequel la prévention de la condensation de vapeur de gravure sur la chambre sous vide comprend le chauffage de la chambre sous vide.

8. Procédé selon la revendication 4, comprenant en outre le contrôle d'une pression dans la chambre sous vide.

9. Procédé selon la revendication 8, dans lequel le contrôle de la pression dans la chambre sous vide comprend au moins un élément sélectionné dans le groupe comprenant : le contrôle d'un flux d'échappement en utilisant un plenum sous vide à chambres multiples, l'injection de gaz dans le plenum sous vide, le contrôle d'une pression partielle de l'agent de gravure, et le chauffage de la chambre sous vide.

10. Procédé selon la revendication 1, dans lequel la disposition de la face arrière d'une tranche contre la courroie perforée comprend la disposition de la face arrière de la tranche au-dessous de la courroie.

11. Procédé selon la revendication 10, dans lequel la disposition de la face arrière d'une tranche contre la courroie perforée comprend en outre le recouvrement d'une seconde perforation de la courroie avec la face arrière de la tranche pour permettre au différentiel de pression de soutenir la tranche contre la courroie via la seconde perforation.

12. Procédé selon la revendication 1, dans lequel la disposition de la face arrière d'une tranche contre la courroie perforée comprend la disposition de la face arrière de la tranche sur la courroie.

13. Procédé selon la revendication 1, dans lequel la tranche a une épaisseur comprise dans une plage d'environ 50 à 250 microns.

14. Procédé selon la revendication 1, comprenant en outre : la mise en contact de la face avant de la tranche avec un rouleau transportant la tranche.

15. Procédé selon la revendication 14, comprenant en outre : le changement d'une distance entre la courroie et le rouleau.

16. Dispositif de gravure chimique comprenant :
une chambre sous vide (114) ;
une courroie perforée (120) positionnée contre la chambre sous vide ; et
une chambre de gravure (130) positionnée sur une face de la courroie perforée (120) opposée à la chambre sous vide,
la chambre de gravure (130) comportant une ouverture (132) dimensionnée pour permettre la libération d'un agent de gravure au travers de celle-ci pour graver une face avant d'une tranche (140) ayant une face arrière disposée contre la courroie (120), la chambre sous vide (114) configurée pour créer un différentiel de pression qui protège la face arrière de la tranche contre l'agent de gravure, dans laquelle le différentiel de pression maintient la tranche contre la courroie et la face avant (142) de la tranche est exposée à l'agent de gravure.

17. Dispositif de gravure chimique selon la revendication 16, dans lequel l'agent de gravure est une vapeur de gravure.

18. Dispositif de gravure chimique selon la revendication 17, dans lequel la chambre sous vide comprend un dispositif de chauffage (116) pour chauffer une surface de la chambre sous vide à une température qui réduit la condensation de la vapeur de gravure sur la chambre sous vide.

19. Dispositif de gravure chimique selon la revendication 16, dans lequel le différentiel de pression génère une force suffisante pour empêcher que de la condensation ne s'égoutte au travers d'une ou de plusieurs perforations de la courroie et n'entre en contact avec la face arrière de la tranche.

20. Dispositif de gravure chimique selon la revendication 16, dans lequel la chambre sous vide (114) est agencée au-dessus d'une partie de la courroie et la chambre de gravure chimique (130) est agencée au-dessous de la partie de la courroie.

21. Dispositif de gravure chimique selon la revendication 16, dans lequel la chambre sous vide est agencée au-dessous d'une partie de la courroie et la chambre de gravure chimique est agencée au-dessus de la partie de la courroie.

22. Dispositif de gravure chimique selon la revendication 16, dans lequel le différentiel de pression extrait à travers une perforation de la courroie (120) de l'agent de gravure non déposé sur la face avant de la tranche.

23. Dispositif de gravure chimique selon la revendication 16, dans lequel la chambre de gravure chimique comprend en outre un échappement configuré pour extraire de l'agent de gravure non déposé sur la tranche.

24. Dispositif de gravure chimique selon la revendication 16, dans lequel une perforation de la courroie est constituée sous forme d'une fente ou d'un trou.

25. Dispositif de gravure chimique selon la revendication 16, dans lequel des perforations de la courroie sont agencées selon un motif correspondant à des positions de tranche.

26. Dispositif de gravure chimique selon la revendication 16, dans lequel la chambre sous vide comporte une surface inférieure perforée (118).

27. Dispositif de gravure chimique selon la revendication 26, dans lequel la surface inférieure perforée de la chambre sous vide est courbée.

28. Dispositif de gravure chimique selon la revendication 26, comprenant en outre :
un rouleau de courroie (162) couplé à la courroie pour glisser la courroie le long de la surface inférieure perforée de la chambre sous vide.

29. Dispositif de gravure chimique selon la revendication 16, dans lequel des dimensions de la courroie sont suffisantes pour transporter simultanément des rangées parallèles de tranches.

30. Dispositif de gravure chimique selon la revendication 16, comprenant en outre :
des rouleaux adjacents à la chambre de gravure chimique, une distance entre les rouleaux et la courroie perforée étant comprise dans une plage d'environ 50 à 250 microns.
